**Europäisches Patentamt**

**European Patent Office**

**Office européen des brevets**

(11) Publication number: **0 196 806**
**B1**

# (12) EUROPEAN PATENT SPECIFICATION

(45) Date of publication of patent specification: **07.11.90**

(51) Int. Cl.⁵: **H 01 L 21/316, C 23 C 16/40**

(21) Application number: **86301742.2**

(22) Date of filing: **11.03.86**

(54) Optimized process for forming borophosphosilicate glass.

(30) Priority: **11.03.85 US 710202**

(43) Date of publication of application:
**08.10.86 Bulletin 86/41**

(45) Publication of the grant of the patent:
**07.11.90 Bulletin 90/45**

(84) Designated Contracting States:
**CH DE FR GB IT LI NL**

(56) References cited:
**US-A-4 546 016**

**RCA REVIEW, December 1970, pages 715-727, Princeton N.J., US; W. KERN et al.: "Deposition and properties of silicon oxide and silicate films prepared by low-temperature oxidation of hydrides"**

**RCA REVIEW, vol. 43, September 1982, pages 423-457, Princeton, New Jersey, US; W. KERN et al.: "Chemically vapor-deposited borophosphosilicate glasses for silicon device applications"**

(73) Proprietor: **APPLIED MATERIALS, INC.**
**3050 Bowers Avenue**
**Santa Clara California 95051 (US)**

(72) Inventor: **Dornfest, Charles N.**
**1429 Kintyre Way**
**San Jose California 95129 (US)**

(74) Representative: **Allard, Susan Joyce et al**
**BOULT, WADE & TENNANT, 27 Furnival Street**
**London EC4A 1PQ (GB)**

(56) References cited:
**SOLID STATE TECHNOLOGY, vol. 28, no. 6, June 1985, pages 171-179, Port Washington, New York, US; W. KERN et al.: "Borophosphosilicate glasses for integrated circuits"**

Courier Press, Leamington Spa, England.

**Description**

In one aspect, the present invention relates to an atmospheric pressure, chemical vapor deposition (APCVD) process for forming silicate glass films used as dielectric layers in integrated circuit structures, at a high deposition rate and with low particulate levels. In particular, the invention relates to the APCVD of borophosphosilicate films with an improvement over the standard process of (1) decreased generation of particulates (which collect on reactor sidewalls and contaminate the deposited films) and (2) increased deposition rate.

The trend to greater device densities and smaller minimum feature sizes and smaller separations in VLSI integrated circuits imposes increasingly stringent requirements on the IC fabrication processes and structures. In particular, regarding the present invention, scaled VLSI interconnect metallization is formed to very fine, small dimensions, which requires excellent conformal coverage of the metallization over the stepped IC surface topography. This conformal coverage is necessary, for example, to prevent electromigration when aluminum is used as the interconnect metallization. In general, it is desirable to round the step corners of and planarize the interlevel dielectric layer which underlies the interconnect metallization, whether the interconnect material is aluminum or some other conductor such as a silicide or a refractory metal or a composite or multilayer structure. Although these various other materials are used, sputter-deposited aluminum is currently the favorite material for interconnects. This is so despite the several problems — including electromigration — which are associated with its use.

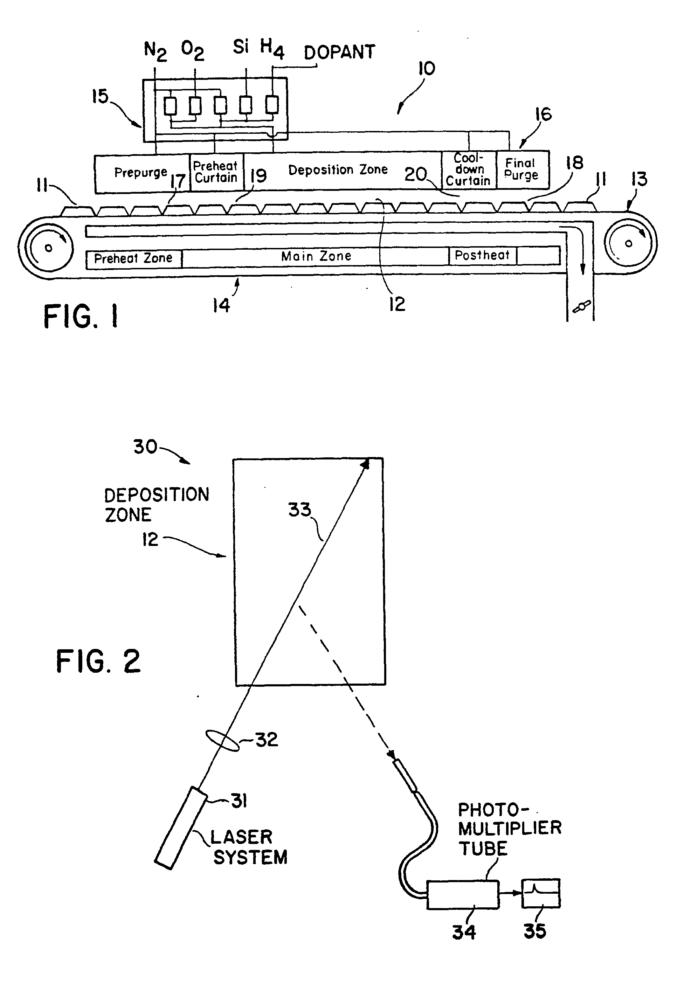

As mentioned, interconnect metallization step coverage is enhanced over the interlevel dielectric by rounding via corners and inducing planarization in the dielectric material. Typically, APCVD phosphosilicate glass (PSG) is used as the interlevel dielectric. The silicate glass is deposited on the IC structure using a reactor such as the reactor 10 shown in FIG. 1. The reactor 10 is a continuous processing, atmospheric pressure Silox® glass reactor which is commercially available from Applied Materials, Inc., Santa Clara, California. The reactor can be used to deposit various dopant levels of silicate glass for use as MOS/bipolar passivation layers and interlayer dielectric layers, as well as solid layer predeposition dopant sources. The wafers are supported on trays 11—11 which are transported through the reactor and the deposition zone 12 by a continuous wafer transport mechanism 13. The reactor is heated by zone heater 14. Gases, including nitrogen, oxygen, silane and dopant such as diborane and phosphine are supplied by a gas control system 15 to the gas dispersion head 16 for application to the various reactor zones. In conjunction with the zoned heater 14, the gas dispersion system provides a cross-flow of gases and the following stages: nitrogen prepurge zone 17 and final purge zone 18 in which the wafers are gradually heated and cooled in nitrogen to prevent contamination; stronger purge curtains (preheat zone 19 and cool down zone 20) in which the temperature is stable; and the deposition zone 12. At a deposition zone temperature of about 425°C, reactor 10 is routinely capable of providing continuous processing Silox® phosphorus-doped silicate glass deposition rates of about 100 nm (1,000 Angstroms) per minute.

After deposition, the interlayer phosphorus-doped silicate glass steps typically are rounded and planarized by reflowing the glass at temperatures of about 1,000°C. However, as IC devices are scaled to smaller, more precise dimensions the diffusion associated with the 1,000°C glass reflow step may cause unwanted deterioration of the scaled doping profiles.

It has been known for some time that borophosphosilicate glass (BPSG) can be reflowed at a lower temperature than PSG, at about 900°C. The use of BPSG is thus advantageous in preventing redistribution of the doping profiles. In addition, the well developed PSG process technology applies to BPSG. As the result of such desirable characteristics, BSSG glass is being used increasingly. However, the standard atmospheric pressure BPSG processes produce a high concentration of small particulates. Such high particulate levels are incompatible with the very stringent low particulate requirements of VLSI devices. The stringent requirements for low particle levels make it necessary to reduce particle levels to the lowest possible levels while maintaining good process control, in order to fully utilize BPSG in present and future devices.

We have now developed a borophosphosilicate glass deposition process which is characterized by low level particulate generation levels and an optimized combination of low particulate levels and high deposition rates.

The attainment of the above objects, i.e., of optimized process conditions, was made possible by the discovery that the fundamental particulate generating mechanism in APCVD silicate film depositions is a gas phase reaction. This discovery led in turn to the discovery that the particulate generation is a temperature-driven process which describes a decreasing monotonic function for temperatures below about 420°C. BPSG deposition rates peak at about 340°C, with the result that the objective of high deposition rate and low particulate levels can be satisfied by a deposition temperature of about 340°C.

Accordingly, the present invention provides a process for forming boron-containing and phosphorus containing glass on a substrate surface, comprising the steps of placing the substrate in an ambient comprising oxygen, and hydrides of silicon, boron, and phosphorus and an inert carrier gas and heating the surface region of the substrate and surface-adjacent region of the ambient to deposit the boron-containing and phosphorus-containing glass on the substrate, the heating being to a temperature of about 340°C at the substrate to deposit the glass at an optimum combination of high deposition rate and low particulate generation level.

In a preferred aspect the present invention is a process for depositing phosphorus-containing and boron-containing silicate glass on semiconductor wafers in the deposition zone of a reaction chamber which further comprises:

placing the wafers on support members in a reaction chamber having a deposition zone; transporting the wafers on the support members through the reaction chamber deposition zone while heating the support member to a temperature of about 340°C; and

supplying a gaseous mixture of oxygen, a hydride of silicon, a hydride of phosphorus and a hydride of boron to the chamber via an inert carrier gas, the oxygen:total hydride ratio of gaseous mixture being greater than about 10.1.

The above and other aspects of the invention are described in detail in conjunction with the drawings in which:

FIG. 1 is a schematic representation of an atmospheric pressure silicate glass deposition reactor of the type used in practicing the present invention;

FIG. 2 is a schematic representation of the laser beam reflection apparatus used to detect and quantify particulate formation and transport in the deposition zone of the reactor of FIG. 1;

FIG. 3 is an Arrhenius plot of particulate density as a function of temperature, and a graph of deposition rate as a function of temperature over the corresponding range within the deposition zone of the reactor of FIG. 1; and

FIGS. 4, 5 and 6 are graphs of particulate concentration as a function, respectively, of reactant flow rates, oxygen-to-hydride ratio obtained by varying the oxygen flow, and oxygen-to-hydride ratio obtained by varying the silane flow.

According to the present invention, atmospheric pressure borophosphosilicate glass, which contains boron in addition to the phosphorus which is contained in phosphosilicate glass, is deposited in an atmospheric pressure reactor at a low temperature of about 340°C. The process uses as reactants a hydride of silicon such as silane, oxygen, a hydride of boron such as diborane and a hydride of phosphorus such as phosphine in an inert carrier gas such as nitrogen. The low temperature provides an optimized deposition reaction in that the deposition rate is high and the gas phase particle generation is decreased. The optimization of the BPSG process deposition rate and particulate control and, in particular, the control of particulates by reducing the substrate temperature and the reactor deposition zone temperature adjacent the substrate, are not suggested by the previous body of knowledge regarding the generation of particulates in CVD reactors such as, for example, the reactor 10, FIG. 1. In such reactors, particulate accumulation is observed at the head 16, and, therefore, it had been frequently assumed that the particulates emerged from the head. There was thus little impetus for reducing the particulates generated at the head, indeed there is little chance of reducing particulates generated at the head, simply because the temperature there is already very low, typically perhaps 100°C. Furthermore, historically the APCVD of silicate glasses has been characterized by high levels of particulates and therefore it has been assumed that little could be done to improve the situation regarding BPSG.

The constraints on lowering particulates in BPSG deposition were removed when it was discovered and verified that particulate generation/formation was not occurring at the reactor head. Referring to FIG. 2, this discovery resulted from the development of a new system for in situ observation of the CVD reaction chamber, indicated generally by the reference numeral 30 in the figure, for investigating the region of the generation and transport of particles in the deposition zone 12 during semiconductor processing. The laser beam scattering particle analysis system 30 utilizes a conventional laser system 31 to direct the laser beam 33 into the deposition zone 12 of the reactor 10, FIG. 1, and thereby illuminate the particles in the deposition zone. Two types of investigation were done. First, a lens 32 was used to spread the laser across essentially the entire deposition zone 12 during BPSG deposition. Particulate flow patterns were visually observed as light reflected off the particles and were photographed in the deposition zone using high speed film. The observations and film revealed a fog of particles entrained in eddy currents which flowed from the region above the surface of the substrates on the trays 11—11 where the temperature is the hottest, to the head 16 and the chamber exhaust. That is, the observed flow patterns were to the head 16, not away from the head.

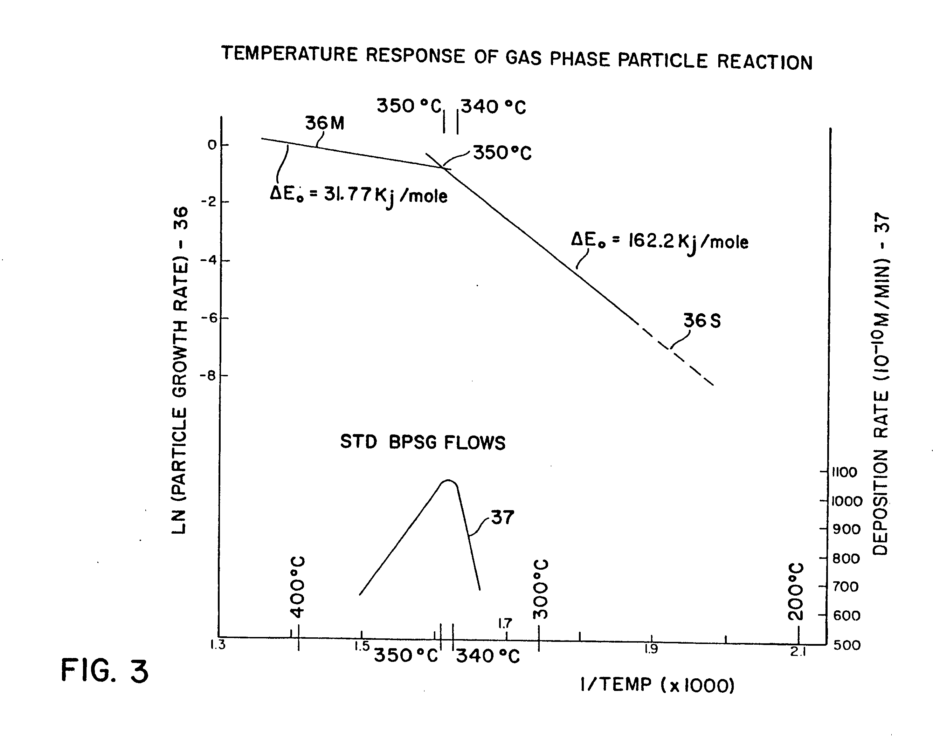

Secondly, particulate levels were quantified by directing the laser beam 33 to a smaller beam spot through the deposition zone, that is, without using the lens 32. A conventional photomultiplier tube 34 was used to sense the intensity of the laser light scattered from the particulates in the deposition zone 12 and responsively provide an analog current output signal to a strip chart recorder 35 so that, in effect, the intensity of light scattered from the particulate byproducts of the deposition reaction was recorded by the strip chart 35. The scattered light intensity was plotted as an Arrhenius plot of the logarithm of particle growth rate verses l/T (T = absolute temperature). The calculations assumed that the particulate generation rate was proportional to the scattered light intensity. The resulting Arrhenius curve, shown in FIG. 3 as curve 36, has the two slopes which are characteristic of gas phase reactions associated with chemical vapor deposition. See, for example, the similar behavior reported for the chemical vapor deposition of undoped silicon dioxide by Middlehock et al, *ECS Abstracts,* 1975. The curve 36 exhibits a mass transport rate-limited regime associated with the slope of the higher temperature section 36M and a surface reaction rate-limited regime associated with the more steeply sloped, lower temperature section 36S. The respective activation energies of 31.77 kz/mole (7.6 KCal/mole) and 162.2 kz/mole (38.8 KCal/mole) associated with the two slopes were obtained by assuming that the reaction rate was proportional to light intensity.

The particulate light scattering observation and quantification discussed relative to FIG. 2 indicated that particulates did not emerge from the head 16, but rather were formed near the heated tray 11 surfaces (where the gas temperatures are the highest). Also, although most particles remain entrained in the flow and are carried out of the reactor, a significant concentration are carried by convection flow away from the wafers toward the head 16 where the particles are observed to collect. This discovery in combination with the gas phase temperature response shown in FIG. 3, indicates that the BPSG particulate formation is a surface reaction rate-limited regime in the temperature region corresponding to the curve section 36S for temperatures below approximately 350°C. In this surface reaction controlled process, the particulate generation is concentrated, i.e., particulates are generated by the gaseous reaction, within a thin surface boundary layer of perhaps several millimeters thickness adjacent the outer surfaces of the wafers. In other words, the particulate generation is a gas phase reaction adjacent the substrate which is a function of temperature and, specifically, a decreasing function of temperature below approximately 350—360°C.

The above temperature dependence is particularly significant when considered in conjunction with the temperature dependence of the BPSG deposition rate. Referring further to FIG. 3, BPSG deposition rate data taken using the reactor 10, FIG. 1, is also plotted as a function of I/T. The shape of this curve 37 is similar to the plot of the deposition rate of borosilicate glass deposition as a function of I/T which is disclosed in Kern et al, *RCA Review*, December, 1970, pp 715—727. The present BPSG deposition rate increases monotonically with decreasing temperature over the range of 420°C to a maximum at 340°C, then decreases monotonically as the temperature is decreased below 340°C. Because the particle generation rate at 340°C is approximately one-third of the rate at the standard process temperature of about 425°C, and because the deposition rate describes a maximum at about 340°C, the deposition temperature of about 340°C is optimum from the standpoint of the combination of high deposition rate and low particulate generation.

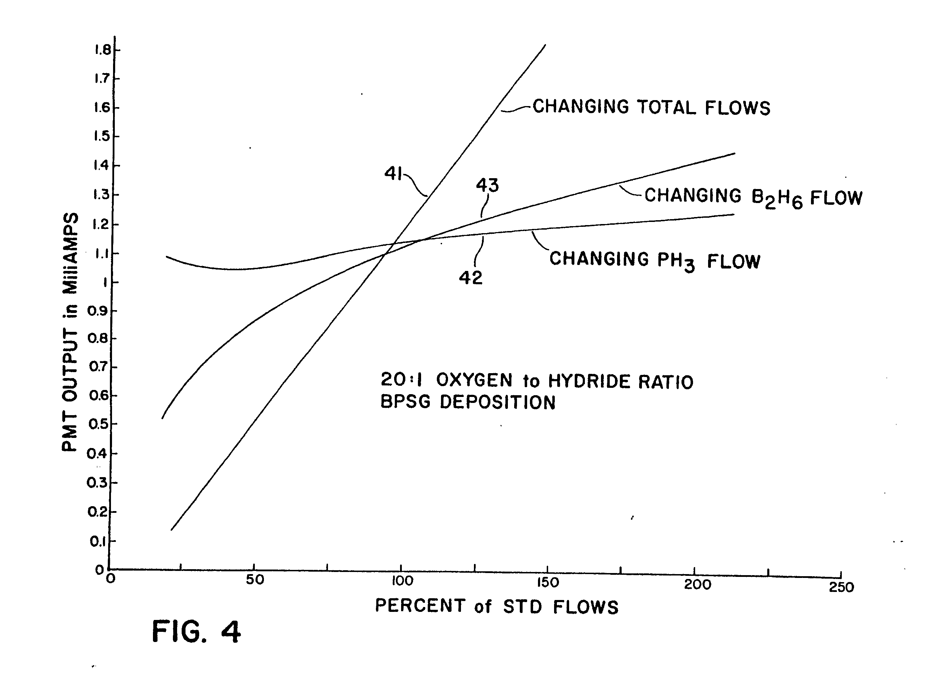

Other data taken for BPSG atmospheric deposition, including data from trend line experiments, indicates the effect of other process variables besides temperature on particulate generation and provides confirming evidence of the surface reaction natures of the gas phase particulate generation process. For example, and referring to FIG. 4, BPSG deposition was performed by varying the flow rate of the gaseous constituents relative to those used in a "benchmark" 420°C BPSG process (which uses $SiH_4$, $O_2$, $B_2H_6$, $PH_3$ and $N_2$ flow rates of, respectively, 185, 4400, 12, 23, and 140,000 sccm). Specifically, the individual hydride flow rates were varied while total hydride flow and oxygen flow were maintained constant to maintain an overall 20:1 oxygen:hydride ratio.

Referring further to FIG. 4, curve 41 represents the change in particulate generation as a function of changes in total reactant flow. Curve 41 indicates that decreasing the total reactant flow substantially reduces particulates over the entire range of flow rates investigated. Curve 42 indicates that the level of generated particulates is relatively insensitive to changes in phosphine. Finally, curve 43 indicates that, at relatively low flow rates, changing diborane substantialy changes the particulate level, but that the rate of change levels off at the higher flow rates necessary for commercially useful films.

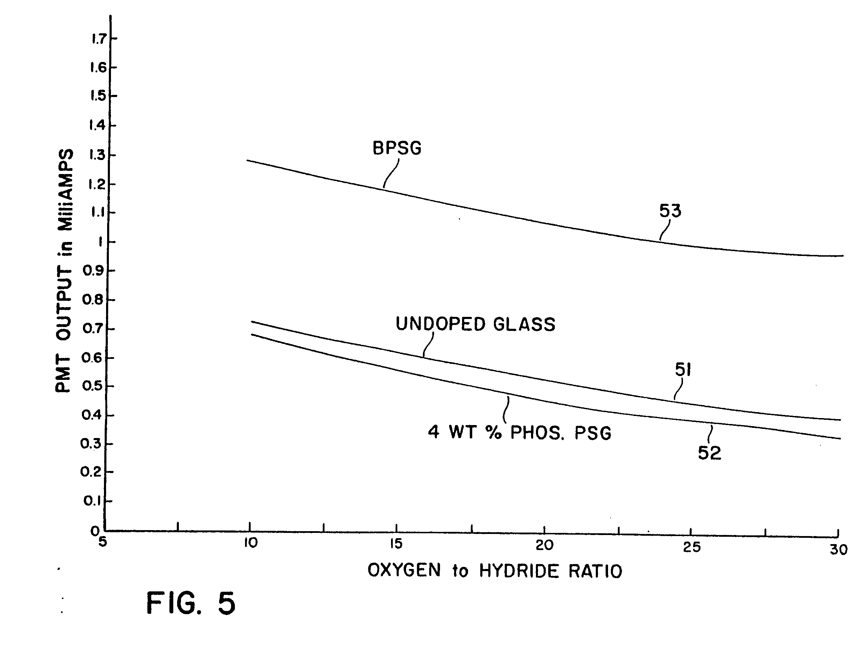

Referring to FIG. 5, there are shown trend lines 51, 52, 53 for particulate generation, respectively, for undoped silicon dioxide, PSG (four weight percent phosphorus) and BPSG (3.7 weight percent boron, 4.5 weight percent phosphorus). The behavior of curve 53 for BPSG is similar to that of the other curves, but the particulate level associated with the BPSG reaction is higher in comparison to the other two systems. Perhaps more importantly, the slowly decreasing plateau region of BPSG curve 53 indicates that particulate levels are at a near minimum for an oxygen:hydride ratio of about 30:1, and is very close to being minimum even at 25:1 (and presumably 35:1), and is not significantly higher at 20:1. Therefore, changing $O_2$:hydride does not strongly affect the generation of particules due to the gas phase reactions. Rather (as shown in FIG. 3) particle generation is much more strongly influenced by temperature. Thus, in conjunction with the critical temperature of about 340°C, which provides the combination of high deposition rate and low temperature-dependent particulate generation, low particulate generation occurs throughout a wide range of oxygen:hydride ratios out to 30:1, and beyond, based upon the asymptotic shape of the curve.

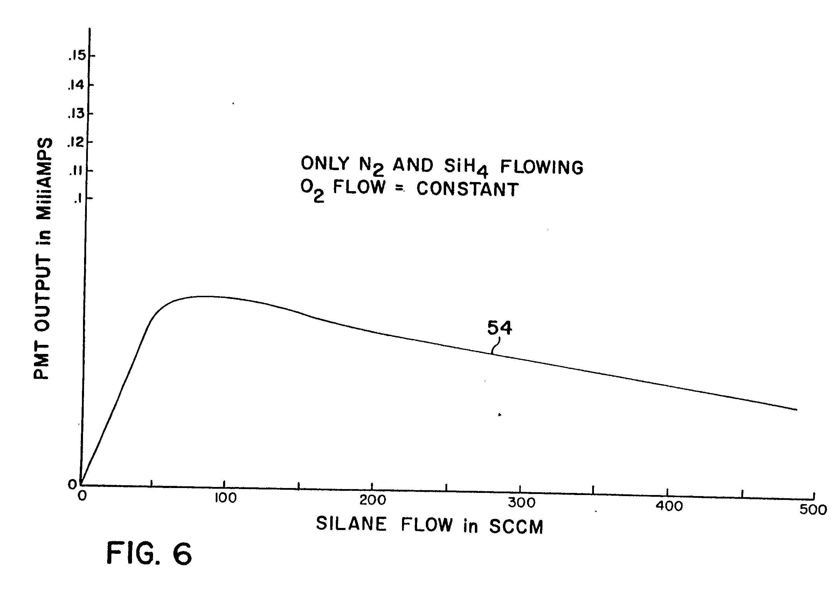

FIG. 6 illustrates additional confirming evidence of the surface reaction nature of the particulate generation during BPSG deposition. FIG. 6 illustrates particulate levels as a function of silane flow for undoped silicate glass using silane, oxygen and nitrogen as reactants at a temperature of 425°C. Here, unlike the data illustrated in FIG. 5, the oxygen:hydride ratio was investigated by varying the hydride flow rate for constant oxygen flow. The plotted data is described by the Langmuir-Hinselwood surface reaction rate model:

$$\text{Reaction Rate} = \frac{a\, P_{O_2} P_{SiH_4}}{(1 + bP_{O_2} + cP_{SiH_4})^2},$$

where the partial pressure of the oxygen, $P_{O_2}$, is constant and that partial pressure of the silane, $P_{SiH_4}$, is varied.

This behavior is considered additional confirming evidence of the surface reaction nature of the particulate generation. The curves 51—53 of FIG. 5 can be expected to exhibit similar behavior if data were taken for oxygen-to-hydride ratios below 10:1.

The Table summarizes the phosphorus content, boron content and deposition rate for groups of BPSG films which were deposited at temperatures over the range 420°C to 340°C, that is, over temperature range for the mass transport rate limited curve 36M, FIG. 3, down to the change to surface reaction rate limited regime. Film uniformity was also measured. The BPSG films were deposited in the reactor 10 using diborane, phosphine, silane and oxygen as the reactant species and nitrogen as the carrier gas. The reactant species were diluted, premixed and then distributed into the reaction chamber. The BPSG films were deposited on bare silicon wafers 100 millimeter and 150 millimeter in diameter moving through the reaction chamber on the continuously moving wafer transport system 13. The deposition temperatures referenced here refer to the measured temperature of the transport trays 11—11. The wafer surface itself is approximately 10—30° cooler than the tray temperature.

Film thickness measurements were made using a Nanospec (Registered Trade Mark) Spectrophotometer. Composition analysis was made using X-ray fluorescence and FTIR. The film analyses summarized in the Table show that lowering the deposition temperature from 420°C to 340°C has negligible effect on boron content and a slight effect on the phosphorus content, which increases by a factor of 1.2. The uniformities of boron and phosphorus content on the six inch diameter wafers were tightly controlled, that is, they were not strongly affected by the temperature change.

TABLE

| DEP TEMP (°C) | DEP RATE (A/MIN) | B (WT%) | P (WT%) |
|---|---|---|---|
| 420 | 770 | 4.3 | 4.6 |
| 380 | 970 | 4.4 | 5.1 |
| 340 | 1050 | 4.4 | 5.4 |

$O_2$:HYDRIDE = 20:1

TOTAL HYDRIDE = 220 sccm

Typical film thickness values varied from ±three percent to ±six percent for wafer-to-wafer and within wafer values based upon the Nanospec five point measurements of the deposited BPSG films, which were about 1 µm (10,000 Angstroms) thick.

Wafer particulate levels resulting from the conventional atmospheric pressure chemical vapor deposition of PSG films have been determined to be about one particle greater in size than one micrometer per square centimeter of wafer surface, using a Surfscan (Registered Trade Mark) instrument. For BPSG films deposited using conventional atmospheric pressure chemical vapor deposition, it is estimated the particulate concentration is about twice that measured for PSG films. Thus, based upon the observed threefold decreased in BPSG particulates which results from using the present low temperature deposition process, it is conservatively estimated that wafer particulate levels would be about 0.5 particles/cm² or lower for the low temperature BPSG process. The decreased particulate generation not only results in decreased direct particle contamination of wafers by the deposition process itself, but also decreases the build-up of particulates on the walls and other surfaces of the reactor, and thereby decreases "indirect" contamination not resulting directly associated with the deposition reaction itself, and/or lengthens the processing intervals before cleaning of the reactor is necessary.

In short, reducing the process temperature below 420°C offers the benefit of increasing the deposition rate and reducing gas phase particulate generation. The particulate levels are low over a wide range of oxide:hydride ratios. While the present low temperature deposition process has been demonstrated using atmospheric pressure, it is applicable as well to similar processes using pressures below atmospheric pressure. Finally, BPSG boron content, the important factor in determining the flow temperature of the films, was virtually independent of temperature over the temperature range investigated. The typical BPSG boron content of about 4 weight percent and greater which is desirable for adequate reflow of BPSG interlayer films at, 900°C, is readily attained.

Thus, there has been described an atmospheric chemical vapor deposition process for depositing boron doped silicate films at an optimum, relatively high deposition rate of about 100 nm (1,000 Angstroms) per minute and a low particulate level, which was reduced by a factor of about 3 relative to the standard 430°C silicate glass process temperatures.

**Claims**

1. A process for forming boron-containing and phosphorus containing glass on a substrate surface, comprising the steps of placing the substrate in an ambient comprising oxygen, and hydrides of silicon, boron, and phosphorus and an inert carrier gas and heating the surface region of the substrate and surface-adjacent region of the ambient to deposit the boron-containing and phosphorus-containing glass on the substrate, the heating being to a temperature of about 340°C at the substrate to deposit the glass at an optimum combination of high deposition rate and low particulate generation level.

2. A process as claimed in claim 1 for depositing phosphorus-containing and boron-containing silicate glass on semiconductor wafers in the deposition zone of a reaction chamber further comprising:

placing the wafers on support members in a reaction chamber having a deposition zone; transporting the wafers on the support members through the reaction chamber deposition zone while heating the support member to a temperature of about 340°C; and

supplying a gaseous mixture of oxygen, a hydride of silicon, a hydride of phosphorus and a hydride of boron to the chamber via an inert carrier gas, the oxygen:total hydride ratio of gaseous mixture being greater than about 10:1.

3. A process as claimed in claim 2 or claim 3, wherein the oxygen to hydride ratio of the gaseous mixture supplied to the reaction chamber is in the range of from 20:1 to 30:1.

4. A process as claimed in any one of the preceding claims wherein the hydride of silicon is silane.

5. A process as claimed in any one of the preceding claims wherein the hydride of phosphorus is phosphine.

6. A process as claimed in any one of the preceding claims wherein the hydride of boron is diborane.

7. A process as claimed in any one of the preceding claims wherein the inert carrier gas is nitrogen.

**Patentansprüche**

1. Verfahren zur Ausbildung eines Bor und Phosphor enthaltenden Glases auf einer Substratfläche, mit den Verfahrensschritten, das Substrat in eine Umgebung zu bringen, die Sauerstoff, Hydride von Silicium, Bor und Phosphor und ein inertes Trägergas aufweist, und den Oberflächenbereich des Substrats und die an die Oberfläche angrenzenden Bereiche der Umgebung zu erhitzen, um das Bor und Phosphor aufweisende Glas auf dem Substrat niederzuschlagen, wobei die Erhitzung auf eine Temperatur von um 340°C an dem Substrat erfolgt, um das Glas bei einer optimalen Kombination von hoher Niederschlagsrate und einer niedrigen Makroteilchen-Erzeugungspegel niederzuschlagen.

2. Verfahren nach Anspruch 1 für das Niederschlagen von Phosphor und Bor enthaltendem Silicatglas auf Halbleiterscheiben in der Niederschalgszone einer Reaktionskammer, dadurch gekennzeichnet,

daß die Scheiben auf Stützteile in einer Reaktionskammer mit einer Niederschlagszone gebracht werden; die Scheiben auf den Stützteilen durch die Reaktionskammer-Niederschlagszone geführt werden, während das Stützteil auf eine Temperatur von etwa 340°C erwärmt wird; und

eine gasförmige Mischung aus Sauerstoff, einem Siliciumhydrid, einem Phosphorhydrid und einem Borhydrid über ein inertes Trägergas zu der Kammer geleitet wird, wobei das Verhältnis zwischen Sauerstoff und den gesamten Hydriden der gasförmigen Mischung größer als etwa 10:1 ist.

3. Verfahren nach Anspruch 2 oder 3, dadurch gekennzeichnet, daß das Verhältnis zwischen Sauerstoff und Hydrid der gasförmigen Mischung, die zu der Reaktionskammer geleitet wird, in dem Bereich von zwischen 20:1 bis 30:1 liegt.

4. Verfahren nach einem der vorhergehenden Ansprüche, dadurch gekennzeichnet, daß das Siliciumhydrid Silan ist.

5. Verfahren nach einem der vorhergehenden Ansprüche, dadurch gekennzeichnet, daß das Phosphorhydrid Phosphin ist.

6. Verfahren nach einem der vorhergehenden Ansprüche, dadurch gekennzeichnet, daß das Borhydrid Diboran ist.

7. Verfahren nach einem der vorhergehenden Ansprüche, dadurch gekennzeichnet, daß das inerte Trägergas Stickstoff ist.

**Revendications**

1. Procédé pour former du verre contenant du bore et contenant du phosphore sur une surface de substrat, comportant les étapes suivantes: on place le substrat dans une ambiance comprenant de l'oxygène et des hydrures de silicium, bore et phosphore et un gaz porteur inerte, et on chauffe la région superficielle du substrat et la région adjacente de l'ambiance pour déposer le verre contenant du bore et contenant du phosphore sur le substrat, le chauffage s'effectuant à une température d'environ 340°C sur le substrat pour déposer le verre en une combinaison de vitesse élevée de dépôt et de niveau bas de formation de particules.

2. Procédé suivant la revendication 1, pour déposer un verre silicaté contenant du phosphore et contenant du bore sur des pastilles de semi-conducteur, dans la zone de dépôt d'une chambre à réaction, comportant en outre:

on place les pastilles sur des organes de support dans une chambre à réaction ayant une zone de dépôt; on transporte les pastilles sur les organes de support à travers la zone de dépôt de la chambre à réaction tandis que l'on chauffe l'organe de support à une température d'environ 340°C; et

on fournit à la chambre un mélange gazeux d'oxygène, d'un hydrure de silicium, d'un hydrure de phosphore et d'un hydrure de bore dans un gaz porteur inerte, le rapport oxygène/hydrures totaux du mélange gazeux étant plus grand qu'environ 10/1.

3. Procédé suivant la revendication 1 ou la revendication 2, où le rapport de l'oxygène aux hydrures du mélange gazeux fourni à la chambre à réaction est dans la gamme de 20/1 à 30/1.

4. Procédé suivant l'une quelconque des revendications précédentes, où l'hydrure de silicium est du silane.

5. Procédé suivant l'une quelconque des revendications précédentes, où l'hydrure de phosphore est de la phosphine.

6. Procédé suivant l'une quelconque des revendications précédentes, où l'hydrure de bore est du diborane.

7. Procédé suivant l'une quelconque des revendications précédentes, où le gaz porteur inerte est de l'azote.

FIG. 1

FIG. 2

# TEMPERATURE RESPONSE OF GAS PHASE PARTICLE REACTION

**FIG. 3**

EP 0 196 806 B1

FIG. 4

EP 0 196 806 B1

FIG. 5

PMT OUTPUT in MilliAMPS

1.7
1.6
1.5
1.4
1.3
1.2
1.1
1
0.9
0.8
0.7
0.6
0.5
0.4
0.3
0.2
0.1
0
5  10  15  20  25  30

OXYGEN to HYDRIDE RATIO

BPSG
53

UNDOPED GLASS
51

4 WT % PHOS. PSG
52

4

FIG. 6